# EUROPEAN PATENT APPLICATION

(11) **EP 0 841 681 A2**
(43) Date of publication of application: **13.05.1998**
(21) Application number: 97308942.8
(22) Date of filing: 07.11.1997
(51) Int. Cl.: H01J 37/304, H01J 37/317, G03F 7/20

(54) **Exposure apparatus and exposure method**

(30) Priority: 07.11.1996 JP 311411/96
(71) Applicant: NIKON CORPORATION, Tokyo (JP)
(72) Inventor: Magome, Nobutaka, c/o Nikon Corporation, Chiyoda-ku, Tokyo (JP)
(74) Representative: Rackham, Stephen Neil

(57) **Abstract**

A projection optical system and an electron optical system are mounted in a vacuum chamber in a side-by-side relationship to each other. An interferometer system controls the position of a substrate stage such that each of the projection optical system and the electron optical system can expose a radiation-sensitive substrate placed on the substrate stage. Therefore, combined exposure can be performed by using light and an electron beam in the same system. For example, the greater part of a predetermined pattern is formed on a radiation-sensitive substrate by exposure using light, and particularly fine pattern elements are formed by exposure using an electron beam.
Alternatively, a pattern is formed on a radiation-sensitive substrate by exposure using light, and then exposure is carried out by using an electron beam to correct the pattern formed by the exposure using light.

## Description

The present invention relates to an exposure apparatus and an exposure method. More particularly, the present invention relates to an exposure apparatus and exposure method which are used in lithography processes to produce semiconductor devices, liquid-crystal display devices, etc.

Typical examples of exposure systems conventionally used in lithography processes to produce semiconductor devices and so forth include optical exposure systems (e.g. steppers) which transfer a mask pattern onto a wafer or other substrate coated with a photosensitive material (resist) by using light, and electron beam exposure systems which expose a resist coated on a substrate by using an electron beam to thereby write a predetermined pattern on the substrate.

As optical exposure systems, 1:1 one-shot projection exposure systems have heretofore been used. However, as the scale of integration of semiconductor devices increases, the pattern size becomes smaller and smaller, and there is a demand for a reduction in the linewidth of patterns. To meet the demand, the mainstream exposure systems have recently been changing to step-and-repeat reduction projection exposure systems which use an emission line (e.g. the i-line) from a mercury vapor lamp as an exposure light source, for example, i-line steppers, and step-and-repeat reduction projection exposure systems which use a KrF excimer laser as an exposure light source, for example, excimer steppers. The reason for this is that systems of this type are suitable for use as exposure systems for mass-production of semiconductor devices in view of the fact that the light source is less costly and that exposure can be made over a wide area.

On the other hand, the pattern forming technique that uses an electron beam is characterized in that this technique enables writing of patterns having a fine linewidth (i.e. fine-line patterns) and per se has the function of generating patterns at high speed without the need for a reticle (photomask) as used in a pattern forming technique using ultraviolet light or X-rays. Accordingly, a variety of electron beam exposure systems, e.g. high-speed photomask or reticle producing systems, have been developed taking notice of the high-speed writing capability of the electron beam lithography technique, and a large number of electron beam exposure systems are used. Aside from these electron beam exposure systems, there exist systems developed mainly for research and development of advanced semiconductor devices and experimental devices, which are known as "electron beam direct writing systems" that write fine-line patterns directly on a resist coated on a wafer.

However, patterns formed on substrates are becoming increasingly finer, and the resolution limit of optical lithography is a matter of concern in the present state of the art. More specifically, in regard to optical exposure systems, an ArF excimer laser light source is said to be a light source of the shortest effective wavelength, and it is also conceivable to use higher laser harmonics as a light source of a shorter wavelength than the ArF excimer laser. However, the ArF excimer laser light source has a problem in terms of electro-energy conversion efficiency. In the case of higher laser harmonics, the conversion efficiency of the relevant substance is low. Accordingly, both light sources suffer from a problem in terms of energy use efficiency. The minimum linewidth is about a half of the wavelength even if the process employs a phase shift method using a phase shift reticle (i.e. a technique whereby the phase of light is shifted through 180 degrees to improve resolution), so-called modified illumination method, and a special resist technique (an improvement in the process technique) known as "multilayer resist method". Therefore, it is difficult for optical exposure systems to attain a level of resolution required in the age of DRAMs of one gigabyte and four gigabytes, which is expected to come materialise.

Electron beam exposure systems (hereinafter occasionally referred to as "EB exposure systems") are capable of writing lines with a fine width but are not suitable for the production of chips with a wide area because an excessively long time is required for writing. Therefore, EB exposure systems are unsatisfactory for the mass- production of semiconductor devices from the viewpoint of throughput.

Under the above-described circumstances, a first object of the present invention is to provide an exposure apparatus capable of forming patterns even finer than in the past at high resolution without causing a considerable reduction in throughput.

A second object of the present invention is to provide an exposure method capable of forming patterns even finer than in the past at high resolution without causing a considerable reduction in throughput.

An exposure apparatus according to a first aspect of the present invention is an apparatus which forms a predetermined pattern on a radiation-sensitive substrate by exposure. The apparatus has a substrate stage moving in a two-dimensional plane, together with the radiation-sensitive substrate placed thereon; a vacuum chamber which accommodates the substrate stage; a projection optical system which forms a pattern by exposure using light on the radiation-sensitive substrate placed on the substrate stage; an electron optical system mounted in a side-by-side relationship to the projection optical system to form a pattern by exposure using an electron beam on the radiation-sensitive substrate placed on the substrate stage; and an interferometer system which controls the position of the substrate stage such that each of the projection optical system and the electron optical system can expose the radiation-sensitive substrate placed on the substrate stage.

According to the above-described arrangement, the projection optical system and the electron optical system are mounted in a side-by-side relationship to each other in the vacuum chamber, and the position of the substrate stage, which moves in the vacuum chamber, is controlled by the interferometer system such that each of the projection optical system and the electron optical system can expose the radiation-sensitive substrate placed on the substrate stage. Therefore, it is possible to form a pattern on the radiation-sensitive substrate by exposure using light and/or by exposure using an electron beam as occasion demands by using the same system. Thus, it is possible to carry out combined exposure by using light and an electron beam: For example, the greater part of a predetermined pattern is formed on a radiation-sensitive substrate by exposure using light, and particularly fine pattern elements are formed by exposure using an electron beam. Alternatively, a pattern is formed on a radiation-sensitive substrate by exposure using light, and then exposure is carried out by using an electron beam to correct the pattern formed by exposure using light. Accordingly, it becomes possible to produce patterns even finer than in the past at high resolution without causing a considerable reduction in throughput by virtue of the advantage of optical exposure that a pattern of wide area can be produced with high throughput and the advantage of electron beam exposure that a fine-line pattern can be produced with high accuracy.

In this case, the interferometer system may be arranged in any form, provided that it controls the position of the substrate stage such that each of the projection optical system and the electron optical system can expose the radiation-sensitive substrate placed on the substrate stage. For example, the interferometer system may have at least three length-measuring axes: a first length-measuring axis in the direction of a first axis connecting the center of an optical axis of the projection optical system and the center of an optical axis of the electron optical system; a second length-measuring axis perpendicularly intersecting the first length-measuring axis at the center of the optical axis of the projection optical system; and a third length-measuring axis perpendicularly intersecting the first length-measuring axis at the center of the optical axis of the electron optical system. With this arrangement, the radiation-sensitive substrate on the substrate stage can be accurately positioned with respect to the exposure position without being affected by an Abbe error due to rotation of the substrate stage regardless of whether exposure is carried out by using light through the projection optical system or by using an electron beam through the electron optical system.

The above-described exposure apparatus may further have a mark detecting system which detects a mark for position detection formed on the radiation-sensitive substrate. The mark detecting system is disposed on the first axis, which connects the center of the optical axis of the projection optical system and the center of the optical axis of the electron optical system. With this arrangement, because the mark detecting system, which detects a mark for position detection formed on the radiation-sensitive substrate, is disposed on the first axis, which connects the center of the optical axis of the projection optical system and the center of the optical axis of the electron optical system, it becomes possible to minimize the movable range of the substrate stage in a direction perpendicular to the first axis. Moreover, if the exposure apparatus is provided with an interferometer system having a length-measuring axis along the first axis, it is possible to accurately control the position of the substrate stage independently of the effect of Abbe error with respect to the direction of the first axis in any of the following operations: optical exposure by the projection optical system; electron beam exposure by the electron optical system; and detection of an alignment mark by the mark detecting system. Further, because the mark detecting system is provided separately from the projection optical system, optical design of the mark detecting system can be made freely. In addition, it is also possible to use a non-optical mark detecting system.

The interferometer system only needs to be capable of measuring the position of the substrate stage over the entire movable range thereof. Therefore, the interferometer system needs at least one length-measuring axis for a direction perpendicular to the first axis. However, it is desirable for the interferometer system to have at least four length-measuring axes: a first length-measuring axis in the direction of the first axis; a second length-measuring axis perpendicularly intersecting the first length-measuring axis at the center of the optical axis of the projection optical system; a third length-measuring axis perpendicularly intersecting the first length-measuring axis at the center of the optical axis of the electron optical system; and a fourth length-measuring axis perpendicularly intersecting the first length-measuring axis at the detection center of the mark detecting system. With this arrangement, the position in two-dimensional directions of the substrate stage can be accurately controlled without being affected by an Abbe error due to rotation of the substrate stage in any of the following operations: optical exposure by the projection optical system; electron beam exposure by the electron optical system; and detection of an alignment mark by the mark detecting system.

An exposure method according to another aspect of the present invention is a method of exposing a radiation-sensitive substrate by using the above-described exposure apparatus. The exposure method includes the first step of forming a pattern on the radiation-sensitive substrate by exposure using the projection optical system; and the second step of performing exposure using the electron optical system to correct the pattern formed on the radiation-sensitive substrate at the first step. According to the exposure method, a pattern is formed on the radiation-sensitive substrate by optical exposure through the projection optical system, and thereafter electron beam exposure is carried out by the electron optical system to correct the pattern formed on the radiation-sensitive substrate. Accordingly, it is possible to produce patterns even finer than in the past at high resolution without causing a considerable reduction in throughput by virtue of the advantage of optical exposure that a pattern of wide area can be produced with high throughput and the advantage of electron beam exposure that a fine-line pattern can be produced with high accuracy. In this case, corrective exposure using an electron beam is carried out subsequently to optical exposure by the same exposure apparatus without changing the radiation-sensitive substrate. Therefore, throughput can be improved even more effectively than in the case of performing corrective exposure using an electron beam by another system subsequently to optical exposure.

In a case where an improvement in the exposure accuracy is demanded more than in throughput, the following method may be used: The method is a process of exposing a radiation-sensitive substrate to form a pattern thereon. The method includes the first step of forming a pattern on the radiation-sensitive substrate by exposure using light; and the second step of exposing the radiation-sensitive substrate using an electron beam to correct the pattern formed at the first step. In this case also, a pattern of wide area can be formed by exposure using light with high throughput, and an unsatisfactory portion of the pattern formed by the optical exposure can be corrected by electron beam exposure. Accordingly, it is possible to produce fine-line patterns with high throughput and with high accuracy in comparison to the conventional practice in which only electron beam exposure is performed.

An exposure apparatus according to another aspect of the present invention has a substrate stage on which a radiation-sensitive substrate is placed; a projection optical system which transfers a predetermined pattern onto the radiation-sensitive substrate by exposure using light; an electron optical system which writes a predetermined pattern on the radiation-sensitive substrate by exposure using an electron beam; a device which changes relative position between the substrate stage and the projection optical system; a device which changes relative position between the substrate stage and the electron optical system; and an interferometer system which controls the relative position between the substrate stage and the projection optical system and the relative position between the substrate stage and the electron optical system such that the projection optical system and the electron optical system can expose the radiation-sensitive substrate placed on the substrate stage.

An exposure apparatus according to another aspect of the present invention has a substrate stage on which a radiation-sensitive substrate is placed; a projection optical system which transfers a predetermined pattern onto the radiation-sensitive substrate by exposure using light, and which has a moving optical system capable of leading light for exposure to a desired position on the radiation-sensitive substrate; an electron optical system which writes a predetermined pattern on the radiation-sensitive substrate by exposure using an electron beam, and which has a moving optical system capable of leading the electron beam for exposure to a desired position on the radiation-sensitive substrate; and an interferometer system which controls a position of the moving optical system of the projection optical system and a position of the moving optical system of the electron optical system such that the projection optical system and the electron optical system can expose the radiation-sensitive substrate placed on the substrate stage.

An exposure apparatus according to another aspect of the present invention has a first exposure system which forms a first pattern on a substrate by exposure using a light beam; a second exposure system which forms a second pattern on the substrate by exposure using an electron beam; and a driving system which moves the substrate such that the first and second patterns are formed on the same area on the substrate. The second pattern may be finer than the first pattern.

An exposure apparatus according to another aspect of the present invention has a first exposure system which transfers a pattern illuminated with a light beam onto a substrate; a second exposure system which exposes at least a part of a divisional area on the substrate, onto which the pattern is transferred, by using an electron beam; and a transfer system which moves the substrate between the first and second exposure systems.

An exposure apparatus according to another aspect of the present invention which is used in a lithography progress in which a micro-device is manufactured, has a stage supporting a radiation-sensitive substrate; a vacuum chamber which accommodates the stage; a first exposure system wherein the radiation-sensitive substrate is exposed to an optical beam; and a second exposure system wherein the radiation-sensitive substrate is exposed to an electron beam.

At least a part of the first exposure system is disposed in the outside of the vacuum chamber and at least a part of the second exposure system is disposed in the outside of the vacuum chamber.

The first exposure system may transfer a device pattern irradiated by the optical beam onto the radiation-sensitive substrate and the second exposure system may irradiate the electron beam to at least a part of a divided area on the radiation-sensitive substrate in which the device pattern has been transferred.

The second exposure system may irradiate the electron beam to a part of the device pattern transferred onto the irradiation-sensitive substrate to correct the part.

The first exposure system may transfer a first portion of a device pattern onto the irradiation-sensitive substrate by exposure and the second exposure system may transfer a second portion of the device pattern, which is different from the first portion, to the irradiation-sensitive substrate by exposure.

A pattern of the second portion may be finer than a pattern of the first portion.

An area of the first portion may be larger than that of the second portion.

The first exposure system may comprise: an illumination system which irradiates the optical beam to a mask; and an optical projection system which projects the optical beam passing through the mask onto the irradiation-sensitive substrate. At least a part of an irradiation-sensitive substrate side of the optical projection system is installed to the vacuum chamber.

The second exposure system may comprise an electromagnetic lens system which irradiates the electron beam onto the irradiation-sensitive substrate and at least a part of an irradiation-sensitive substrate side of the electromagnetic lens system may be installed to the vacuum chamber.

The second exposure system may be a system using one method selected from a pencil beam method, a variable-shaped-beam method, a cell-projection method and a blanking-aperture-array method or a system using a combination of some methods selected from a pencil beam method, a variable-shaped-beam method, a cell-projection method and a blanking-aperture-array method.

An exposure apparatus according to another aspect of the present invention which is used in a lithography progress in which a micro-device is manufactured, has an optical projection system which projects an image of at least a part of a first pattern illuminated by an optical beam onto an irradiation-sensitive substrate; an electron optical system which irradiates an electron beam onto the irradiation-sensitive substrate to transfer a second pattern; a vacuum chamber to which the optical projection system and the electron optical system are connected; and a device disposed in the vacuum chamber which moves the irradiation-sensitive substrate so that the first pattern and second pattern are transferred to the same area of the irradiation-sensitive substrate.

An exposure method according to another aspect of the present invention of transferring a device-pattern onto an irradiation-sensitive substrate has the steps of: transferring a first pattern illuminated by an optical beam onto the irradiation-sensitive substrate; and transferring a second pattern to a divided area on the irradiation-sensitive substrate, to which the first pattern has been transferred, using an electron beam.

The second pattern may be finer than the first pattern.

Fig. 1 is a diagram schematically showing the arrangement of an exposure apparatus according to one embodiment of the present invention.

Fig. 2 is a schematic plan view of the exposure apparatus shown in Fig. 1 in a state where a top panel of a vacuum chamber is removed.

Fig. 3 is a block diagram schematically showing the arrangement of a control system used in the exposure apparatus shown in Fig. 1.

Fig. 4 is a cross-section showing the inside of an electron lens barrel.

Fig. 5 (A) through Fig. 5 (D) are an explanatory drawing showing an embodiment of exposure for correction using an electron beam.

Fig. 6 (A) through Fig. 6 (D) are an explanatory drawing showing another embodiment of exposure for correction using an electron beam.

Fig. 7 is an explanatory drawing showing an embodiment of an exposure method of the present invention wherein a part of a device pattern is transferred onto a wafer by optical exposure and then the remaining portion of the device pattern is transferred onto an area of the wafer, to which the part of the device pattern has been transferred, by electron exposure using an electron beam.

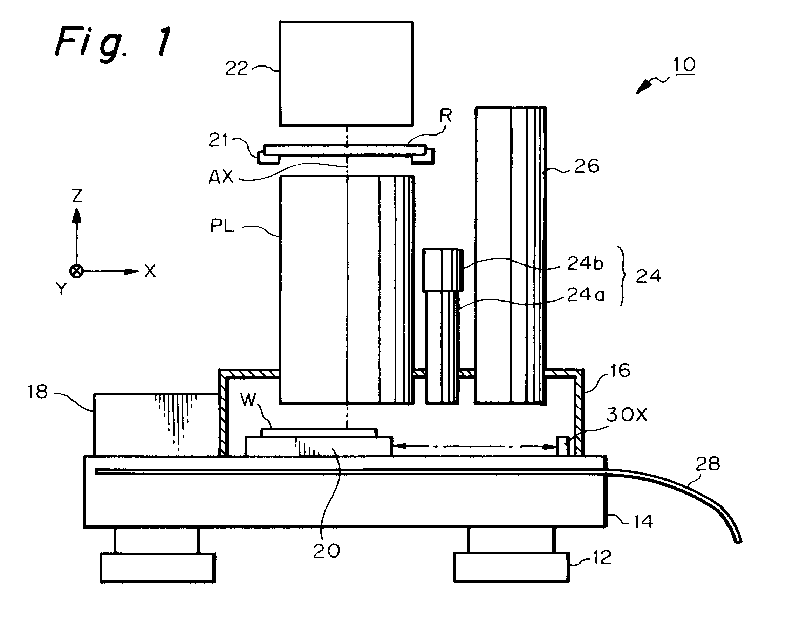

One embodiment of the present invention will be described below with reference to Figs. 1 through 3.

Fig. 1 shows schematically the arrangement of an exposure apparatus 10 according to one embodiment of the present invention. The exposure apparatus 10 has a wafer stage table 14 horizontally held over an installation floor where the exposure apparatus 10 is installed, through a plurality (four in this embodiment) of antivibration plates 12 (two of them that are at the back of the plane of the figure are not shown). A vacuum chamber 16 and a wafer change chamber 18 are mounted on the wafer stage table 14. The vacuum chamber 16 accommodates a wafer stage 20 as a substrate stage that two-dimensionally moves over the wafer stage table 14. A projection optical system PL is attached to the top panel of the vacuum chamber 16. The lower end of the projection optical system PL extends into the vacuum chamber 16. A reticle stage 21 is disposed directly above the projection optical system PL to hold a reticle (photomask) R horizontally. An illumination system 22 is disposed directly above the reticle R. An off-axis alignment sensor 24 as a mark detecting system and an electron lens barrel 26 as an electron optical system are attached to the top panel of the vacuum chamber 16. The respective lower ends of the alignment sensor 24 and the electron lens barrel 26 extend into the vacuum chamber 16.

The four antivibration plates 12 each have a vibration-isolating pad, e.g. a mechanical damper comprising a helical compression spring placed in a damping fluid, or a pneumatic damper. The vibration-isolating pad used in each antivibration plate 12 has a certain level of centering function. The four antivibration plates 12 isolate, on the micro-G level, microvibrations acting on the wafer stage table 14, which are transmitted from the installation floor. It should be noted that one example of a specific arrangement of an antivibration mechanism is disclosed in Japanese Patent Application Unexamined Publication (KOKAI) No. 8-166043 [U.S. Patent Application Serial No. 08/539,080 (filed on Oct. 4, 1995)].

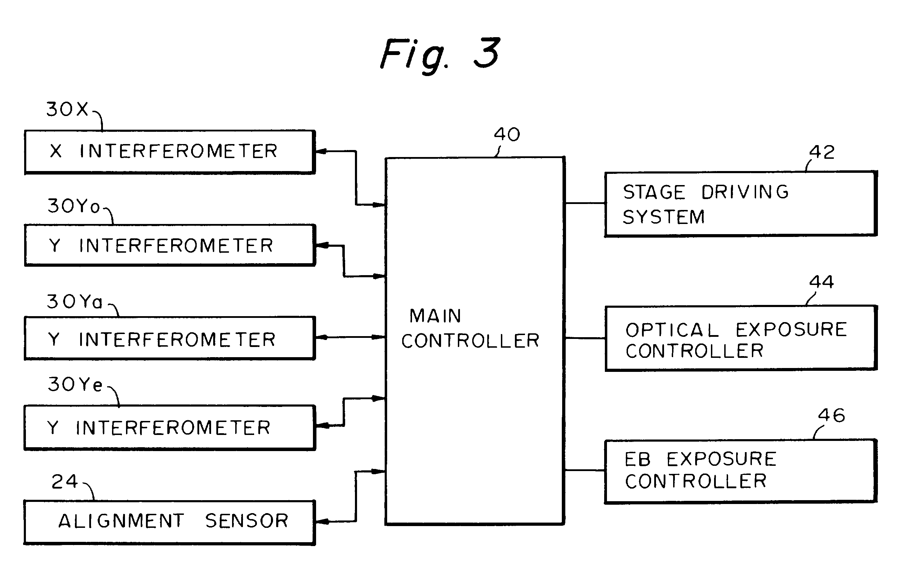

The wafer stage table 14 has an electromagnetic coil (not shown; which is like a stationary-side coil of a moving magnet type linear motor) buried therein. Electromagnetic force from the electromagnetic coil drives the wafer stage 20 having a permanent magnet (or an electromagnet; not shown) buried in the bottom thereof. More specifically, the electromagnetic coil (not shown) buried in the wafer stage table 14 and the permanent magnet (or electromagnet; not shown) buried in the bottom of the wafer stage 20 constitute a stage driving system 42 (see Fig. 3). The stage driving system 42 drives the wafer stage 20 to move in two-dimensional directions in a non-contact fashion. Accordingly, it is unnecessary to provide a mechanical feed screw, a guide rail, etc. in the vacuum chamber 16 in this embodiment.

A waste heat pipe 28 is laid throughout the inside of the wafer stage table 14 to discharge heat generated during the movement of the wafer stage 20 and during optical exposure and electron beam exposure (described later) to the outside. The heat (waste heat) exhausting mechanism will be described later.

The vacuum chamber 16 and the wafer change chamber 18 are adjacent to each other through a communicating door (not shown). The inside of the vacuum chamber 16 is defined as a vacuum chamber kept at a high vacuum. On the other hand, the inside of the wafer change chamber 18 is defined as a vacuum chamber placed under a slightly lower degree of vacuum than in the vacuum chamber 16. The wafer change chamber 18 makes it unnecessary to communicate the inside of the vacuum chamber 16 directly with the outside when wafers are changed, for example. Consequently, the degree of vacuum in the vacuum chamber 16 will not drop undesirably (i.e. a high vacuum can be maintained). In actuality, the wafer change chamber 18 accommodates a wafer exchanging mechanism (not shown) to exchange wafers between the outside and the wafer change chamber 18 and between the wafer change chamber 18 and the wafer stage 20 in the vacuum chamber 16. One example of a specific arrangement of the wafer exchanging mechanism is disclosed in Japanese Patent Application Unexamined Publication (KOKAI) No. 7-240366 [U.S. Patent Application Serial No. 08/395,315 filed by the present applicant (filing date: Feb. 28, 1995)].

The wafer stage 20 is supported in the vacuum chamber 16 in the state of floating over the upper surface of the wafer stage table 14 with a predetermined clearance through a vacuum pre-loaded air bearing (not shown). The wafer stage 20 is driven to move in the XY-plane in a non-contact state by the above-described stage driving system 42. A wafer W as a radiation-sensitive substrate is held through a wafer holder (not shown) on the wafer stage 20. In this embodiment, the surface of the wafer W is coated with a resist (e.g. a chemically amplified resist) that enables both exposure using light and exposure using an electron beam.

The wafer stage 20 is made of a ceramic material having excellent heat dissipation properties and thermal conductivity. The reason for this is that the use of such a ceramic material enables heat generated during the movement of the wafer stage 20 and during optical exposure and electron beam exposure (described later) to be readily dissipated from the wafer stage table 14 and also readily discharged to the outside through the waste heat pipe 28 laid throughout the inside of the wafer stage table 14. The heat exhausting mechanism will be briefly explained below. In general, the wafer stage 20 is supported in the state of floating over the wafer stage table 14 as stated above, and heat accumulates in the wafer stage 20 during the movement thereof and during exposure. Therefore, a heat exhaust position is predetermined, and when the wafer stage 20 comes to the heat exhaust position, the vacuum pre-loaded air bearing is brought into an inoperative state to allow the wafer stage 20 to drop onto the wafer stage table 14 by gravity. Thus, the heat accumulated in the wafer stage 20 is transferred to the wafer stage table 14 and discharged to the outside through the waste heat pipe 28 laid throughout the inside of the wafer stage table 14. It is most desirable to set the heat exhaust position at a standby position where the wafer stage 20 waits for the wafer W to be changed.

The wafer stage 20 has mirror surfaces respectively provided on the right side thereof as shown in Fig. 1 and on the side thereof at the back of the plane of the figure. Laser interferometers 30 are disposed in the vacuum chamber 16 so as to face opposite to the two mirror surfaces, respectively (however, Fig. 1 only shows an X interferometer 30X that projects a laser beam onto the right side of the wafer stage 20 and receives the reflected light from it to measure the position in the X-axis direction of the wafer stage 20; illustration of the interferometers disposed at the back of the plane of the figure is omitted).

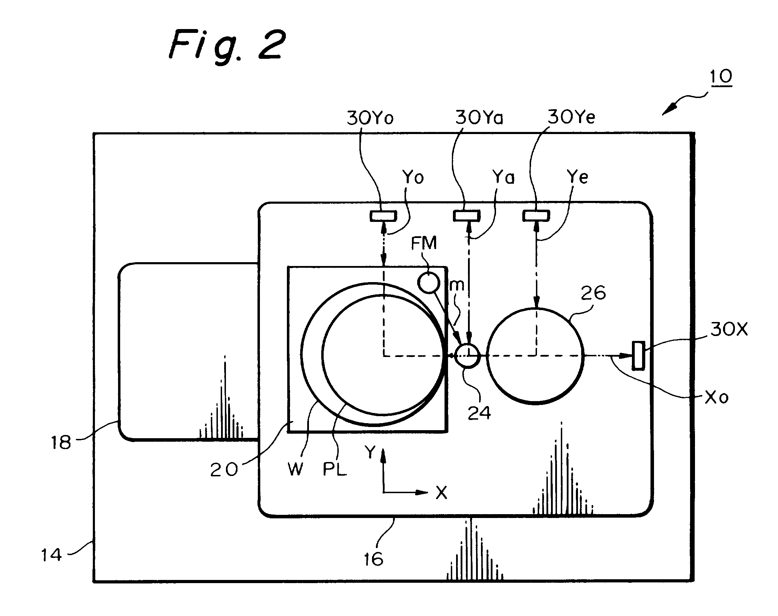

Next, the arrangement of an interferometer system including these interferometers, together with the positional relationship between the projection optical system PL, the alignment sensor 24 and the electron lens barrel 26, will be described with reference to Fig. 2.

Fig. 2 is a schematic plan view of the exposure apparatus 10 in a state where the top panel of the vacuum chamber 16 is removed. As shown in Fig. 2, the projection optical system PL, the alignment sensor 24 and the electron lens barrel 26 are disposed at predetermined intervals along the X-axis direction.

The X-position of the wafer stage 20 is measured by the X interferometer 30X having a length-measuring axis Xo as a first length-measuring axis in the X-axis direction that passes through the centers of the respective optical axes of the projection optical system PL, the alignment sensor 24 and the electron lens barrel 26.

There are provided three Y interferometers for position measurement in the Y-axis direction, i.e. a Y-axis interferometer 30Yo for optical exposure, a Y-axis interferometer 30Ya for alignment, and a Y-axis interferometer 30Ye for electron beam exposure. The Y-axis interferometer 30Yo has a length-measuring axis Yo (second length-measuring axis). The Y-axis interferometer 30Ya has a length-measuring axis Ya (fourth length-measuring axis). The Y-axis interferometer 30Ye has a length-measuring axis Ye (third length-measuring axis). The length-measuring axes Yo, Ya and Ye perpendicularly intersect the length-measuring axis Xo at the centers of the optical axes of the projection optical system PL, the alignment sensor 24 and the electron lens barrel 26, respectively, thereby preventing an Abbe error from being introduced into the measured value by each interferometer. The interferometers 30X, 30Yo, 30Ya and 30Ye are each adapted to measure the position of an object (the wafer stage 20 in this case) in the direction of the measurement axis (length-measuring axis) by measuring a relative displacement of the object from a reference position [the position of a fixed mirror (not shown)] in the direction of the measurement axis. For example, heterodyne type Twyman-Green interferometers may be used as the interferometers 30X, 30Yo, 30Ya and 30Ye. In this embodiment, the four interferometers 30X, 30Yo, 30Ya and 30Ye constitute an interferometer system that controls the position of the wafer stage 20.

As will be clear from Fig. 2, in this embodiment, the wafer stage 20 is a small-sized wafer stage in which the length of one side is only slightly longer than the diameter of the wafer W. Accordingly, it seems that the interferometer beams from the interferometers 30Yo, 30Ya and 30Ye may miss the wafer stage 20, depending upon the position of travel of the wafer stage 20, and it may become impossible to control the position of the wafer stage 20. However, no problem arises in this embodiment because it employs a method in which a main controller 40 (described later; see Fig. 3) resets the interferometers 30Yo, 30Ya and 30Ye on the basis of the measured value by the interferometer 30X having the length-measuring axis Xo (this method will hereinafter be referred to as "stage reset method" for the sake of convenience). In a word, the stage reset method allows an interferometer necessary for measurement or positioning to be reset to an operable state immediately before it is used (the specific contents of the stage reset method will be described later in detail).

In this embodiment, the alignment sensor 24 is an image processing type alignment sensor as disclosed in U.S. Patent No. 5,493,403, i.e. an FIA (Field Image Alignment) sensor. The alignment sensor 24 has an image-formation optical system 24a and a sensor head part (containing a light source and a two-dimensional image pickup device, e.g. a CCD) 24b. The light source (not shown; e.g. a halogen lamp) in the sensor head part 24b emits broadband illuminating light. The illuminating light passes through an objective lens (not shown) constituting the image-formation optical system 24a and is then applied to the wafer W [or a fiducial plate (described later)]. The applied illuminating light is reflected from a wafer mark area (not shown) on the surface of the wafer W and returns to the inside of the image-formation optical system 24a. The reflected light passes successively through the objective lens and an index board (not shown) and forms an image of a wafer mark and an image of an index, which is provided on the index board, on the image pickup surface of the CCD or the like in the sensor head part 24b. The images are photoelectrically converted by the CCD or the like, and the resulting signals are processed by a signal processing circuit (not shown). Then, the relative position of the wafer mark and the index is calculated by an arithmetic circuit (not shown).

It should be noted that the alignment sensor 24 is not necessarily limited to an FIA sensor. It is also possible to use other optical alignment systems, e.g. an LIA (Laser Interferometric Alignment) sensor as disclosed, for example, in U.S. Patent No. 5,151,750, or an LSA (Laser Step Alignment) sensor; other optical devices, e.g. a phase contrast microscope or a differential interference microscope; and non-optical devices, e.g. an STM (Scanning Tunnel Microscope) that detects an atomic level of irregularities on the sample surface by making use of the tunnel effect, or an AFM (Atomic Force Microscope) that detects an atomic or molecular level of irregularities on the sample surface by utilizing atomic forces (attraction and repulsion forces).

The sensor head part 24b generates heat during use. Therefore, the sensor head part 24b is disposed outside the vacuum chamber 16. It is desirable to cool the surroundings of the sensor head part 24b by air-cooling or the like during use.

The electron lens barrel 26 contains an electron gun and exposes the resist on the wafer W by an electron beam generated from the electron gun. It is possible to use either an electron optical system of the type in which an electron beam from an electron gun is focused to form a spot beam, and this is raster- or vector-scanned, as disclosed, for example, in U.S. Patent No. 5,387,799, or an electron optical system of the type in which an electron beam generated from an electron gun is shaped as desired by a combination of apertures (stencil masks), and the shaped electron beam is applied to a necessary spot by a deflector or the like to perform exposure, as disclosed, for example, in U.S. Patent No. 5,283,440. The matter of importance is that exposure using an electron beam is capable of forming satisfactorily fine patterns in comparison to optical exposure.

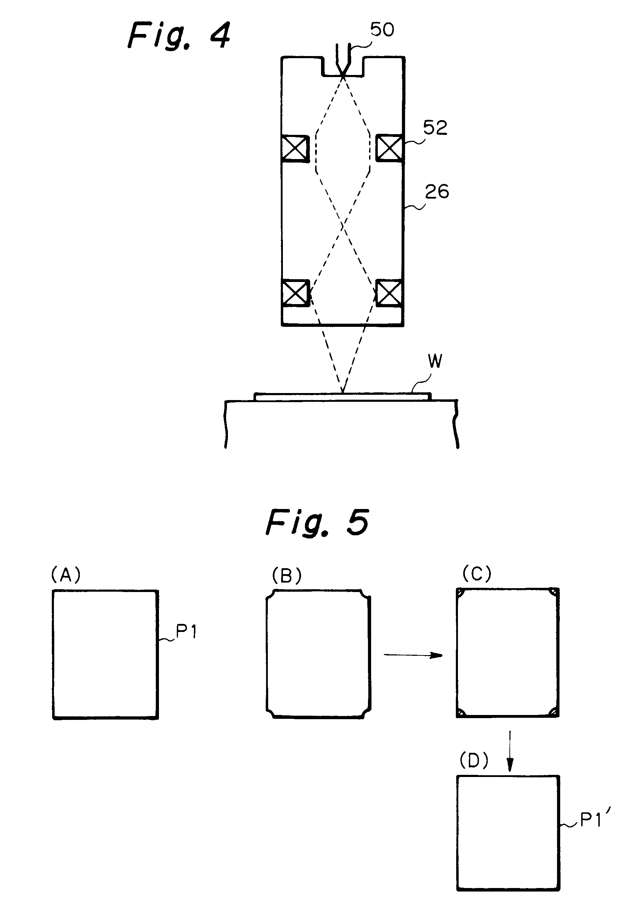

Fig. 4 shows an example of the internal structure of the electron lens barrel 26. The electron lens barrel 26 shown in Fig. 4 is an electron optical system of pencil beam type (Gaussian beam type) which has an electron gun 50, a first electromagnetic lens 52 and a second electromagnetic lens 54. In the electron lens barrel 26 shown in Fig. 4, an electron beam emitted from the electron gun 50 is accelerated by an electromagnetic lens system comprising the first electromagnetic lens 52 and the second electromagnetic lens 54 to which voltage is applied, respectively, and is focused to form a spot electron beam. The resist coated on the wafer W is exposed by the spot electron beam. In Fig. 4, although the internal structure of the electron lens barrel 26 is simply shown, it should be noted that actually objective apertures, deflection electrodes, detecting devices for reflected electron, astigmatic compensating coils and etc. are provided with the electron lens barrel 26.

One type selected from the following types can be used as the electron lens barrel 26:
(1) an electron optical system of a cell-projection type by which a simple pattern pre-shaped on a mask (aperture) such as a square and a parallelogram with every sides 5 micrometers long and etc. is projected;
(2) an electron optical system of variable-shaped-beam type wherein a mask (aperture) on which a pattern which is slightly more complicated than a pattern shaped by the system of a cell-projection type is pre-shaped, is exposed to an electron beam of which section shape is, for example, a square with every sides 5 micrometers, and a pattern corresponding to a section shape of the electron beam passing through the mask is projected;
(3) an EBDW (EB direct drawing method) including, for example, a blanking-aperture-array method wherein a mask with a plurarity of shutters is used (usually, the shutters are composed by such a manner that electrodes are formed with a matrix arrangement on a dielectric material mask and voltage is applied or not applied to each of the electrodes so that each of the electrodes functions as a kind of a condender); and
(4) an EBPS (EB projection system) wherein an squre area with every sides about 250 micrometers is exposured by one-shot exposure using the same mask (the stencil mask) as that used in the optical exposure system.

Alternatively, any combination of the pencil beam method and the above-systems (or method) (1) to (4) may be used as the electron lens barrel which is the second exposure system. It is important that the second exposure system can perform finer exposure than exposure by the optical exposure system.

The illumination system 22 includes a light source (e.g. an excimer laser), a shutter, a blind, an input lens, a fly's-eye lens, a relay lens, a main condenser lens, and so forth (none of them are shown in the figure), as disclosed, for example, in U.S. Patent No. 5,307,207.

The illumination system 22 illuminates a pattern on the lower surface (pattern forming surface) of the reticle R with a uniform illuminance distribution of illuminating light for exposure from the light source. The illuminating light for exposure is monochromatic light (or quasi-monochromatic light). The wavelength (exposure wavelength) of the illuminating light is, for example, 248 nanometers of KrF excimer laser, 193 nanometers of ArF excimer laser, etc.

The reticle stage 21 on which the reticle R is placed can be finely driven by a driving system (not shown) to move in the following directions: an X direction (a lateral direction in the plane of Fig. 1); a Y direction (a direction perpendicular to the plane of Fig. 1) and a O-direction (a direction of rotation in the XY-plane).

The projection optical system PL has an optical axis AX set in a Z-axis direction perpendicular to the XY-plane. In this embodiment, the projection optical system PL is telecentric on both sides and has a predetermined reduction magnification β(β is 1/5, for example). Accordingly, if the reticle R is illuminated with a uniform illuminance by the illuminating light in a state where the pattern of the reticle R and a shot area on the wafer W have been aligned, the pattern on the pattern forming surface is projected onto the resist-coated wafer W as an image demagnified at the reduction magnification β by the projection optical system PL. In this way, the demagnified image of the pattern is formed in each shot area (e.g. an area of each LSI chip) on the wafer W.

In this embodiment, a step-and-repeat optical exposure system is constructed of the illumination system 22, the reticle stage 21 having the reticle R placed thereon, the projection optical system PL, the wafer stage 20 that moves in the XY-plane with the wafer W held thereon, the stage driving system 42 (comprising the electromagnetic coil in the wafer stage table 14 and the permanent magnet in the wafer stage 20 as stated above), the interferometers 30X, 30Yo and 30Ya and the control system for these constituent elements. That is, each shot area on the wafer W is placed at the exposure position (directly below the projection optical system PL), and the reticle pattern is projected and thereby transferred onto the shot area by exposure.

Fig. 3 shows schematically the arrangement of the control system of the exposure apparatus 10 according to this embodiment. The control system is mainly constructed of a main controller 40 comprising a minicomputer (or a microcomputer) that includes a CPU (Central Processing Unit), a ROM, a RAM, etc. The main controller 40 is connected with the above-described four interferometers 30X, 30Yo, 30Ya and 30Ye. The main controller 40 is further connected with the above-described alignment sensor 24 and various controllers, e.g. an optical exposure controller 44 and an EB exposure controller 46.

As will be readily imagined from Fig. 3, in this embodiment the main controller 40 monitors the measured values from the interferometers 30X, 30Yo, 30Ya and 30Ye, and while doing so, controls the stage driving system 42 including the electromagnetic coil (not shown) buried in the wafer stage table 14, thereby controlling the movement of the wafer stage 20. Thus, the main controller 40 also serves as a stage controller that controls the movement of the wafer stage 20.

The optical exposure controller 44 controls optical exposure by ON/OFF controlling the light source (not shown) in the illumination system 22 and also controlling an opening and closing operation of the shutter (not shown) in the illumination system 22. The EB exposure controller 46 controls electron beam exposure by controlling the electron gun, deflector, etc. (none of them are shown) in the electron lens barrel 26. The optical exposure controller 44 and the EB exposure controller 46 are placed under the control of the main controller 40.

Next, the function of the main controller 40 according to this embodiment will be described with respect mainly to the stage reset function and with reference to Figs. 2 and 3.

The stage reset function of the main controller 40 works as follows: When any of the interferometric beams sent along the length-measuring axes Yo, Ya and Ye misses the wafer stage 20 during the movement of the wafer stage 20 and hence the interferometer having the relevant length-measuring axis becomes unable to carry out measurement, the interferometer concerned is reset when a predetermined reference point on the wafer stage 20 comes to the reset position for this interferometer on the basis of the measured value obtained from the X interferometer 30X (whose interferometric beam will never miss the wafer stage 20) having the length-measuring axis Xo.

The stage reset function of the main controller 40 will be described below in more detail. As shown in Fig. 2, a fiducial plate FM is provided on the upper surface of the wafer stage 20. The fiducial plate FM is set such that the surface of the fiducial plate FM is approximately flush with the surface of the wafer W. The fiducial plate FM has various fiducial marks formed on the surface thereof (none of them are shown in the figure).
① Assuming that the wafer stage 20 is in the position shown in Fig. 2 upon completion of a wafer change operation, the interferometric beam from the Y-axis interferometer 30Ya is missing the wafer stage 20 in this state, but the interferometric beam along the length-measuring axis Xo will never miss the wafer stage 20. Moreover, the interferometric beam along the length-measuring axis Yo is successful in striking the wafer stage 20. Therefore, the measured values by the interferometers 30X and 30Yo are inputted to the main controller 40. Accordingly, the main controller 40 can recognize the present two-dimensional coordinate position in the XY-plane of the wafer stage 20 on the basis of the measured values from the interferometer 30X and 30Yo. In addition, the main controller 40 accurately recognizes the fact that the interferometric beam along the length-measuring axis Ya (and that along the length-measuring axis Ye) is missing the wafer state 20 on the basis of the X-coordinate of the wafer stage 20. It should be noted that at this time the Y-axis interferometer 30Yo has been reset as described later, and that the wafer stage 20 is controlled on the basis of an (Xo,Yo) coordinate system having an origin defined by a point at which the center of the fiducial plate FM was positioned approximately directly below the optical axis of the projection optical system PL in the previous operation (i.e. the previous reset position of the Y-axis interferometer 30Yo).

Next, while monitoring the measured value from the Y-axis interferometer 30Yo, the main controller 40 drives the wafer stage 20 to move in the -Y direction as shown in Fig.2 until the Yo coordinate reaches zero. Consequently, the center of the fiducial plate FM becomes approximately coincident with the length-measuring axis Xo. Then, while monitoring the measured value from the interferometer 30X, the main controller 40 moves the wafer stage 20 in the +X direction to place the fiducial plate FM at a position approximately directly below the alignment sensor 24. In this state, the main controller 40 measures the position of a predetermined fiducial mark on the fiducial plate FM (e.g. a mark formed in the center of the fiducial plate FM) with respect to the center of an index in the alignment sensor 24 on the basis of the output from the alignment sensor 24. At the same time, the main controller 40 resets the interferometer 30Ya having the length-measuring axis Ya.

Consequently, the position of the wafer stage 20 is controlled according to an (Xo, Ya) coordinate system based on the measured values from the interferometers 30X and 30Ya.

In the case of Fig. 2, the interferometric beam from the interferometer 30Yo does not miss the wafer stage 20 at the reset position for the interferometer 30Ya. Therefore, the movement of the wafer stage 20 from the position shown in Fig. 2 to a position at which the fiducial plate FM lies approximately directly below the alignment sensor 24 may be performed along a straight-line path shown by the arrow m in Fig. 2 on the basis of the measured values from the interferometers 30X and 30Yo.

However, in a case where the length-measuring axes Yo and Ya are more away from each other, for example, the interferometric beam from the interferometer 30Yo will miss the wafer stage 20 during the above-described movement, resulting in a failure to control the position of the wafer stage 20. In contrast, the above-described method, in which the wafer stage 20 is once moved in the -Y axis direction and then moved in the +X direction, enables the interferometer 30Ya to be reset at a predetermined reset position (e.g. a position at which the fiducial plate FM lies directly below the alignment sensor 24) without making it impossible to control the position of the wafer stage 20.

Thereafter, alignment measurement is carried out. More specifically, the main controller 40 measures the positions of position detection marks (wafer marks) of predetermined specific sample shots in a plurality of shot areas on the wafer W on the (Xo, Ya) coordinate system on the basis of the output from the alignment sensor 24 by successively moving the wafer stage 20 while monitoring the measured values from the interferometers 30X and 30Ya. Then, a statistic calculation is performed by the method of least square as disclosed, for example, in U.S. Patent No. 4,780,617 (Japanese Patent Application Unexamined Publication (KOKAI) No. 61-44429) by using the measured position of the wafer mark of each sample shot and design shot area array data, thereby obtaining overall array data concerning the plurality of shot areas on the wafer W. It should be noted that the result of the calculation is desirably converted into data based on the center position of the fiducial plate FM.
② Upon completion of the above alignment measurement (it is assumed that in this state the interferometric beam from the interferometer 30Yo is missing the wafer stage 20), the process proceeds to the exposure processing sequence.

That is, while monitoring the measured values from the interferometers 30X and 30Ya, the main controller 40 moves the wafer stage 20 through the stage driving system 42 to a position at which the fiducial plate FM lies approximately directly below the alignment sensor 24. Thereafter, while monitoring the measured value from the interferometer 30X, the main controller 40 moves the wafer stage 20 in the -X direction to a position at which the fiducial plate FM lies approximately directly below the projection optical system PL.

Next, the main controller 40 measures a relative positional displacement between a predetermined fiducial mark on the fiducial plate FM imaged through the projection optical system PL and a reticle mark on the reticle R by using a reticle microscope RA. At the same time, the main controller 40 resets the interferometer 30Yo. Consequently, the position of the wafer stage 20 is controlled on the coordinate system (Xo, Yo) again.

Then, while monitoring the measured values from the interferometers 30X and 30Yo, the main controller 40 positions each shot area on the wafer W with respect to the exposure position on the basis of the result of the measurement of the relative positional displacement and the previously calculated shot array data, and successively transfers the reticle pattern onto the wafer W by the step-and-repeat method while properly opening and closing the shutter in the illumination system 22 through the optical exposure controller 44.

Upon completion of the transfer of the reticle pattern by exposure, the main controller 40 moves the wafer stage 20 to a position directly below the electron lens barrel 26 to write particularly fine patterns and/or to correct pattern elements that could not satisfactorily be formed by the above-described optical exposure.

The movement of the wafer stage 20 at this time is performed by a procedure similar to that described above in ①. In a state where the fiducial plate FM is positioned approximately directly below the electron lens barrel 26, the Y-axis interferometer 30Ye having the length-measuring axis Ye is reset by the main controller 40. Consequently, the position of the wafer stage 20 is controlled on an (Xo, Ye) coordinate system. While monitoring the measured values from the interferometers 30X and 30Ye, the main controller 40 positions a shot area to be subjected to corrective exposure with respect to the exposure position (directly below the electron lens barrel 26). Then, corrective exposure using an electron beam is carried out through the EB exposure controller 46 with the wafer stage 20 held stationary or being moved.

Embodiments of the progress of transferring a reticle pattern to a wafer by exposure through the optical projection system PL using the optical beam and then correcting an image of the pattern transferred onto the wafer by exposure through the electron lens barrel 26 using an electron beam will be described hereinafter with reference to Fig. 5.

In a case where such a rectangular pattern P1 as shown in Fig. 5 (A) is transferred onto a wafer W, on which a positive-type resist is applied, by exposure through the optical projection system PL using an illumination light for exposure, resolution of four corner portions of the rectangular pattern is quite often insufficient, for example, as shown in Fig. 5 (B). In this case, the wafer stage 20 is moved and then the four corner portions which are shown as oblique line portions in Fig. 5 (c) are corrected by exposure using the electron beam from the electron lens barrel 26 so that the desired pattern P1' shown in Fig. 5 (D) can be finally obtained after developing.

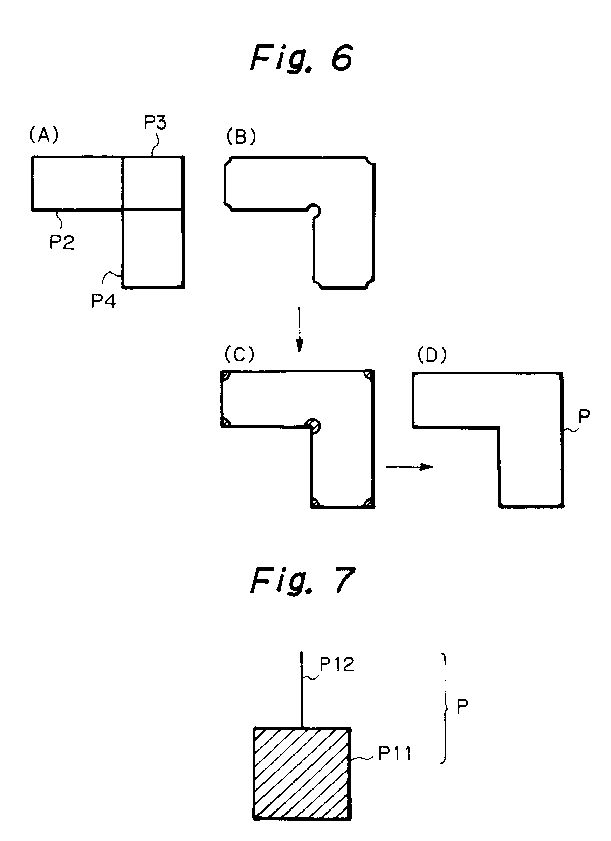

In a case where a L-type pattern which is a combination of rectangular patterns P2, P3 and P4 shown in Fig. 6 (A) is transferred onto a wafer W, on which a positive-type resist is applied, by exposure through the optical projection system PL using an illumination light for exposure, resolution of each of corner portions of the L-type pattern is quite often insufficient as shown in Fig. 6 (B). In this case, the wafer stage 20 is moved and then the corner portions which are shown by oblique line portions in Fig. 6 (C) are corrected by exposure using the electron beam from the electron lens barrel 26 so that the desired L-type pattern P shown in Fig. 6 (D) can be finally obtained after developing.

In a case where, as shown in Fig. 7, a pattern P which comprises a first large quadrilateral pattern P11 (for example, a part of a memory cell) and a second line pattern P12 connecting to the first pattern P11 (for example, a part of a peripheral circuit or a part of an electrical writing) is transferred to a wafer W, the first pattern P11 is first formed to a reticle R and then is transferred to a wafer W by optical exposure through the optical projection system PL. Next, the wafer stage 20 is moved and then the second pattern P12 is transferred to the wafer W by electron exposure using electron beam through the electron lens barrel 26. In this case, the merit of optical exposure that the large area pattern can be transferred by exposure with high throughput and the merit of electron exposure that fine patterns can be transferred by exposure with high accuracy can be obtained. Therefore, without any remarkable drop of throughput, it is possible to transfer a pattern on a reticle partially including very fine patterns by exposure with high resolution.

In the case of the above-described exposure for correction, although an EB direct drawing method such as a Gaussian beam method, a cell-projection method, a variable-shaped-beam method, a blanking-aperture-array method and etc. is more effective in exposure for finer correction, when one device pattern is transferred to a wafer W by exposure with dividing into each portion of the device pattern, the EBPS method is better than the EB direct drawing method because larger area can be exposed with one-shot. Of course in a case where a width of line of a pattern to be transferred is very fine, the Gaussian beam method is most effective because a line of about 0.2 nanometer width can be transferred by the electron exposure.

As has been described above, the exposure apparatus 10 according to this embodiment has the projection optical system PL for optical exposure and the electron lens barrel 26 for electron beam exposure, which are provided together in the vacuum chamber 16. Accordingly, almost all pattern elements can be formed over a wide area by exposure using light. On the other hand, exposure using an electron beam makes it possible to write the finest pattern portion and to correct a pattern portion undesirably reduced in length or having corners undesirably rounded by the optical exposure because of insufficient resolution. That is, exposure using an electron beam is expected to provide a high resolution of the order of 0.2 nanometer and hence enables exceedingly fine corrective exposure. Accordingly, fine-line patterns can be formed at high resolution with throughput maintained at a high level by forming most of the pattern elements by exposure using light and then carrying out corrective exposure for the exposed pattern elements by using an electron beam.

When electron beam exposure is continuously performed subsequently to optical exposure, the wafer need not be replaced. Therefore, it is possible to reduce a loss of time in switching from optical exposure to EB exposure and hence possible to improve throughput correspondingly. Although in the foregoing embodiment the exposure method in which a pattern formed on a radiation-sensitive substrate by optical exposure is corrected by exposure using an electron beam is carried out by the same system, it should be noted that the exposure method may be carried out by using an optical exposure system and an electron beam exposure system for the respective exposure processes. In such a case also, a pattern of wide area is formed with high throughput by exposure using light, and a pattern portion unsatisfactorily formed by the optical exposure can be corrected by exposure using an electron beam. Therefore, fine-line patterns can be formed with high throughput and high accuracy in comparison to a case where only electron beam exposure is carried out.

Moreover, because the exposure apparatus 10 according to this embodiment employs the stage reset method, the length of each side of the wafer stage 20 can be reduced to a value only slightly greater than the wafer diameter. Accordingly, it is possible to achieve a reduction in the overall size of the apparatus, including the vacuum chamber. Thus, it is also possible to avoid degradation of stage moving and control performance which would otherwise be caused by an increase in the size and weight of the stage.

However, in a case where the length of a mirror surface of the wafer stage (or a moving mirror if used) that receives interferometric beams is set sufficiently long to simultaneously receive all the three interfero-metric beams along the length-measuring axes Yo, Ya and Ye so that none of the beams will miss the wafer stage 20, the stage reset method does not necessarily need to be employed.

Further, in the foregoing embodiment because the greater part of the optical projection system PL and the greater part of the electron lens barrel 26 are positioned in the outside of the vacuum chamber 16, in comparison with a case wherein all of the optical projection system PL and all of the electron lens barrel 26 are accommodated in the vacuum chamber 16, the capacity of the vacuum chamber 16 can be well reduced, time for vacuum feed can be reduced and the capacity of a vacuum pump can be reduced so that the cost thereof is also reduced. Therefore, negative effects caused in the vacuum chamber 16 by heat generated when exposure by using of the optical projection system PL and the electron lens barrel 26 will be reduced, specially when the portion exposed outside of the vacuum chamber is cooled, the negative effects will be further reduced.

Although in the foregoing embodiment an interferometer is reset when a fiducial mark on the fiducial plate FM is placed in a predetermined reset position, it should be noted that another mark, for example, a specific alignment mark on the wafer W may be used as a position reference in place of the fiducial mark on the fiducial plate FM.

Further, the exposure apparatus 10 according to the described embodiment has the following advantage: Because the wafer stage 20 moves in the vacuum chamber 16, the interferometers 30X, 30Yo, 30Ya and 30Ye that control the position of the wafer stage 20 are not substantially affected by the fluctuation of air or sound waves. Therefore, it is possible to achieve an improvement in the stage position control accuracy. In addition, because optical alignment and EB alignment can be used jointly, alignment can be made with high accuracy for various wafers to be processed.

Although in the foregoing embodiment the optical exposure system that constitutes the exposure apparatus 10 is a step-and-repeat exposure system, it should be noted that the present invention is not necessarily limited thereto, and that a step-and-scan or other scanning exposure system (e.g. U.S. Patent Nos. 5,194,893, 5,448,332 and 5,591,958), or a stitching exposure system (e.g. U.S. Patent No. 5,473,410) may be used together with the electron lens barrel 26 to form the exposure apparatus 10.

Although in the foregoing embodiment an off-axis alignment sensor is provided as an alignment system, a TTR and/or TTL alignment sensor as disclosed, for example, in U.S. Patent Nos. 5,489,986 and 5,151,750 may be provided in place of or together with the off-axis alignment sensor.

Although in the foregoing embodiment the projection optical system PL, the alignment sensor 24 and the electron lens barrel 26 are disposed to lie in a straight line, the present invention is not necessarily limited thereto. However, in a case where the projection optical system PL, the alignment sensor 24 and the electron lens barrel 26 are not aligned with each other, it is necessary to increase the number of interferometers for the X-axis direction in order to prevent occurrence of an Abbe error.

Moreover, because a wafer changer is incorporated in the wafer change chamber 18, it is possible to exchange a wafer between the wafer change chamber 18 and the outside in parallel to the alignment and exposure carried out in the vacuum chamber 16. Accordingly, the overall throughput can be improved by an amount corresponding to the overlap of the processing operations. From this point of view, two wafer change chambers and two wafer stages may be provided so that while alignment and exposure are being carried out on one wafer stage side, wafer change and heat exhaust processing are executed on the other wafer stage side.

Although in the foregoing embodiment the wafer stage 20 is moved to align the wafer W with the position of the projection optical system PL or the electron lens barrel 26, the arrangement may be such that the position of the wafer W is fixed, and the projection optical system PL and the electron lens barrel 26 are moved to align with the position of the wafer W. In this case, an interferometer system is provided to control the positions of the projection optical system PL and the electron lens barrel 26.

Further, the arrangement may be such that to carry out optical exposure or electron beam exposure, not only the wafer stage 20 is moved, but also the projection optical system PL or the electron lens barrel 26 is moved to align with the position of the wafer W. In this case, an interferometer system is provided to control the position of the wafer stage 20 and the positions of the projection optical system PL and the electron lens barrel 26.

Further, the arrangement may be such that the position of the wafer W is fixed, and the projection optical system PL and the electron lens barrel 26 are each provided with a moving optical system capable of leading light for exposure or an electron beam for exposure to a desired position on the wafer W. In this case, to expose the wafer W by light, the moving optical system of the projection optical system PL is moved to lead light to a predetermined position on the wafer W to perform exposure. Thereafter, the moving optical system of the projection optical system PL is moved so as not to interfere with electron beam exposure. Then, the moving optical system of the electron lens barrel 26 is moved to lead an electron beam to a predetermined position on the wafer W to carry out electron beam exposure. In such an embodiment of the present invention, an interferometer system is provided to control the position of the moving optical system of the projection optical system PL and the position of the moving optical system of the electron lens barrel 26.

Further, the arrangement may be such that an electron beam exposure system which transfers a pattern formed on a mask onto a wafer as disclosed, for example, in U.S. Patent No. 5,079,112 is provided as the electron lens barrel 26, and that a first pattern which is relatively coarse is transferred onto each of a plurality of shot areas on the wafer W by using the projection optical system PL, and a second pattern which is a fine-line pattern is transferred onto each of the shot areas by using the electron beam exposure system so as to be overlaid on the first pattern, thereby effecting double exposure (multiple exposure). It is also possible to use as the electron lens barrel 26 a direct writing type electron beam exposure system disclosed in the above-mentioned U.S. Patent No. 5,387,799 or a cell projection type electron beam exposure system disclosed in U.S. Patent No. 5,283,440.

As has been described above, the exposure apparatus according to the present invention has the novel advantage that it is possible to form even finer patterns than in the past at high resolution without causing a considerable reduction in throughput.

In addition, the present invention provides an exposure method capable of forming even finer patterns than in the past at high resolution without causing a considerable reduction in throughput.

Although the present invention has been described through specific terms, it should be noted here that the described embodiments are not necessarily exclusive and that various changes and modifications may be imparted thereto without departing from the scope of the invention which is limited solely by the appended claims.

The entire disclosure of Japanese Patent Application No. HEI 8-311411 (1996/311411) filed on November 7, 1996 including the specification, claims, drawings and summary is incorporated herein by reference in its entirety.

## Claims

1. An exposure apparatus which forms a predetermined pattern on a radiation-sensitive substrate by exposure, said apparatus comprising:
a substrate stage moving in a two-dimensional plane, together with said radiation-sensitive substrate placed thereon;
a vacuum chamber which accommodates said substrate stage;
a projection optical system which forms a pattern by exposure using light on said radiation-sensitive substrate placed on said substrate stage;
an electron optical system mounted in a side-by-side relationship to said projection optical system to form a pattern by exposure using an electron beam on said radiation-sensitive substrate placed on said substrate stage; and
an interferometer system which controls a position of said substrate stage such that each of said projection optical system and said electron optical system can expose said radiation-sensitive substrate placed on said substrate stage.

2. An apparatus according to claim 1, wherein said interferometer system has at least three length-measuring axes including a first length-measuring axis in a direction of a first axis connecting a center of an optical axis of said projection optical system and a center of an optical axis of said electron optical system, a second length-measuring axis perpendicularly intersecting said first length-measuring axis at the center of the optical axis of said projection optical system, and a third length-measuring axis perpendicularly intersecting said first length-measuring axis at the center of the optical axis of said electron optical system.

3. An apparatus according to claim 1, further comprising a mark detecting system which detects a mark for position detection formed on said radiation-sensitive substrate, said mark detecting system being disposed on a first axis connecting a center of an optical axis of said projection optical system and a center of an optical axis of said electron optical system.

4. An apparatus according to claim 3, wherein said interferometer system has at least four length-measuring axes including a first length-measuring axis in a direction of said first axis, a second length-measuring axis perpendicularly intersecting said first length-measuring axis at the center of the optical axis of said projection optical system, a third length-measuring axis perpendicularly intersecting said first length-measuring axis at the center of the optical axis of said electron optical system, and a fourth length-measuring axis perpendicularly intersecting said first length-measuring axis at a detection center of said mark detecting system.

5. An exposure method using the exposure apparatus of claim 1 to expose said radiation-sensitive substrate, said method comprising:
the first step of forming a pattern on said radiation-sensitive substrate by exposure using said projection optical system; and
the second step of performing exposure using said electron optical system to correct said pattern formed on said radiation-sensitive substrate at said first step.

6. An exposure method of exposing a radiation-sensitive substrate to form a pattern thereon, said method comprising:
the first step of forming a pattern on said radiation-sensitive substrate by exposure using light; and
the second step of exposing said radiation-sensitive substrate by using an electron beam to correct said pattern formed at said first step.

7. An exposure apparatus comprising:
a substrate stage on which a radiation-sensitive substrate is placed;
a projection optical system which transfers a predetermined pattern onto said radiation-sensitive substrate by exposure using light;
an electron optical system which writes a predetermined pattern on said radiation-sensitive substrate by exposure using an electron beam;
a device which changes relative position between said substrate stage and said projection optical system;
a device which changes relative position between said substrate stage and said electron optical system; and
an interferometer system which controls the relative position between said substrate stage and said projection optical system and the relative position between said substrate stage and said electron optical system such that said projection optical system and said electron optical system can expose said radiation-sensitive substrate placed on said substrate stage.

8. An exposure apparatus comprising:
a substrate stage on which a radiation-sensitive substrate is placed;
a projection optical system which transfers a predetermined pattern onto said radiation-sensitive substrate by exposure using light, said projection optical system having a moving optical system adapted to lead light for exposure to a desired position on said radiation-sensitive substrate;
an electron optical system which writes a predetermined pattern on said radiation-sensitive substrate by exposure using an electron beam, said electron optical system having a moving optical system adapted to lead the electron beam for exposure to a desired position on said radiation-sensitive substrate; and
an interferometer system which controls position of said moving optical system of said projection optical system and position of said moving optical system of said electron optical system such that said projection optical system and said electron optical system can expose said radiation-sensitive substrate placed on said substrate stage.

9. An exposure apparatus comprising:
a first exposure system which forms a first pattern on a substrate by exposure using a light beam;
a second exposure system which forms a second pattern on said substrate by exposure using an electron beam; and
a driving system which moves said substrate such that said first and second patterns are formed on a same area on said substrate.

10. An apparatus according to claim 9, wherein said second pattern is finer than said first pattern.

11. An exposure apparatus comprising:
a first exposure system which transfers a pattern illuminated with a light beam onto a substrate;
a second exposure system which exposes at least a part of a divisional area on said substrate, onto which said pattern is transferred, by using an electron beam; and
a transfer system which moves said substrate between said first and second exposure systems.

12. An exposure apparatus which is used in a lithography progress in which a micro-device is manufactured, said exposure apparatus comprising:
a stage supporting a radiation-sensitive substrate;
a vacuum chamber which accommodates said stage;
a first exposure system wherein said radiation-sensitive substrate is exposed to an optical beam; and
a second exposure system wherein said radiation-sensitive substrate is exposed to an electron beam,
at least a part of said first exposure system being disposed in the outside of said vacuum chamber,
at least a part of said second exposure system being disposed in the outside of said vacuum chamber.

13. An apparatus according to claim 12, wherein said first exposure system transfers a device pattern irradiated by said optical beam onto said radiation-sensitive substrate and said second exposure system irradiates said electron beam to at least a part of a divided area on said radiation-sensitive substrate in which said device pattern has been transferred.

14. An apparatus according to claim 13, wherein said second exposure system irradiates said electron beam to a part of said device pattern transferred onto said irradiation-sensitive substrate to correct the part.

15. An apparatus according to claim 12, wherein said first exposure system transfers a first portion of a device pattern onto said irradiation-sensitive substrate by exposure and said second exposure system transfers a second portion of said device pattern, which is different from said first portion, to said irradiation-sensitive substrate by exposure.

16. An apparatus according to claim 15, wherein a pattern of said second portion is finer than a pattern of said first portion.

17. An apparatus according to claim 15, wherein an area of said first portion is larger than that of said second portion.

18. An apparatus according to claim 12, wherein said first exposure system comprises:
an illumination system which irradiates said optical beam to a mask; and
an optical projection system which projects said optical beam passing through said mask onto said irradiation-sensitive substrate,
at least a part of an irradiation-sensitive substrate side of said optical projection system being installed to said vacuum chamber.

19. An apparatus according to claim 12, wherein said second exposure system comprises an electromagnetic lens system which irradiates said electron beam onto said irradiation-sensitive substrate, at least a part of an irradiation-sensitive substrate side of said electromagnetic lens system being installed to said vacuum chamber.

20. An apparatus according to claim 12, wherein said second exposure system is a system using one method selected from a pencil beam method, a variable-shaped-beam method, a cell-projection method and a blanking-aperture-array method or a system using a combination of some methods selected from a pencil beam method, a variable-shaped-beam method, a cell-projection method and a blanking-aperture-array method.

21. An exposure apparatus which is used in a lithography progress in which a micro-device is manufactured, said exposure apparatus comprising:
an optical projection system which projects an image of at least a part of a first pattern illuminated by an optical beam onto an irradiation-sensitive substrate;
an electron optical system which irradiates an electron beam onto said irradiation-sensitive substrate to transfer a second pattern;
a vacuum chamber to which said optical projection system and said electron optical system are connected; and
a device disposed in said vacuum chamber which moves said irradiation-sensitive substrate so that said first pattern and second pattern are transferred to the same area of said irradiation-sensitive substrate.

22. An exposure method of transferring a device-pattern onto an irradiation-sensitive substrate, said method comprising the steps of:
transferring a first pattern illuminated by an optical beam onto said irradiation-sensitive substrate; and
transferring a second pattern to a divided area on said irradiation-sensitive substrate, to which said first pattern has been transferred, using an electron beam.

23. An method according to claim 22, wherein said second pattern is finer than said first pattern.
